# EUROPÄISCHE PATENTSCHRIFT

(11) **EP 0 777 934 B1**
(45) Veröffentlichungstag und Bekanntmachung des Hinweises auf die Patenterteilung: **12.03.2003**
(21) Anmeldenummer: 96914975.6
(22) Anmeldetag: 23.04.1996
(51) Int. Cl.: H03K 17/95

(54) **STÖRFELDSICHERER NÄHERUNGSSCHALTER**
PROXIMITY SWITCH INSENSITIVE TO INTERFERING FIELDS
COMMUTATEUR DE PROXIMITE PROTEGE CONTRE LES PARASITES

(30) Priorität: 22.06.1995 DE 19522668
(43) Veröffentlichungstag der Anmeldung: 11.06.1997
(73) Patentinhaber: SICK AG, 79183 Waldkirch (DE)
(72) Erfinder: SOYCK, Gerno, D-58553 Halver (DE)
(74) Vertreter: Manitz, Finsterwald & Partner
(86) Internationale Anmeldenummer: EP9601686
(87) Internationale Veröffentlichungsnummer: WO97001222

(56) Entgegenhaltungen:
- EP-A- 0 179 384
- EP-A- 0 279 268
- EP-A- 0 360 263

## Beschreibung

Die Erfindung bezieht sich auf einen magnetfeldbetätigten Näherungsschalter, wie er in vielen Bereichen der Technik für die berührungslose Einleitung und Durchführung von elektrischen Schalt-, Steuer- und Regelvorgängen verwendet wird.

Ein derartiger Näherungsschalter ist beispielsweise nach Ausbildung und Funktion in der DE 40 03 426 A1 beschrieben. Demgemäß wird der vermittels eines Amorphmetallkörpers hoher Permeabilität durch Wirbelstromverluste vorbedämpfte HF-Schwingkreis einer Oszillatorschaltung als Sensor von dem Magnetfeld eines sich nähernden Auslösers entdämpft und dieser Vorgang zur Steuerung einer nachgeordneten Schalteinrichtung benutzt.

Dabei ist der definiert durch ein veränderbares Magnetfeld zu betätigende Sensor des Näherungsschalters im besonderen Maße störanfällig gegenüber irgendwelchen Fremdmagnetfeldern in seiner näheren Umgebung. Derartige Störfelder treten z.B. auf Grund hoher Stromstärken besonders bei elektrischen Schweißeinrichtungen auf und können die dort zur apparativen Steuerung der Anlage vorhandenen Sensoren außer Funktion setzen.

Die EP-A 0 179 384 beschreibt einen störfesten magnetbetätigten Näherungsschalter, bei dem zwei Sensoren im Abstand von einander angeordnet und mit einer Differenzschaltung verbunden sind; hierbei ist das vom zu detektierenden Maschinenelement erzeugte Differenzsignal größer als das durch Störfelder erzeugte Differenzsignal.

Der Erfindung liegt daher die Aufgabe zugrunde, einen Näherungsschalter der gattungsgemäßen Art gegen die Beeinflussung durch magnetische Störfelder zu sichern, welche in einem Betriebsablauf wechselnd und in Zwischenräumen auftreten.

Zur Lösung dieser Aufgabe ist gemäß der Erfindung bei einem magnetfeldbetätigten Näherungsschalter nach dem Oberbegriff des Patentanspruchs 1 vorgesehen, daß der zweite Sensor auf intermittierend entstehende magnetische Störfelder reagiert und in seinem aktivierten Zustand das gerade vorhandene Ausgangssignal der Schaltstufe zur Aufrechterhaltung des von dem funktionsbestimmenden Magnetfeldsensor abgegebenen Leitsignals an den Eingang der Verstärkerstufe zurückführt.

Demgemäß ist das zu neutralisierende Störfeld nicht ständig vorhanden, sondern nur intermittierend auf einen gerade betätigten oder gerade unbetätigten Näherungsschalter wirksam. Dabei erfolgt durch die erfindungsgemäße Rückführung des entsprechenden Ausgangssignals der Schaltstufe an den Eingang der Verstärkerstufe eine Überlagerung desselben mit dem Leitsignal von Seiten des Magnetfeldsensors im Sinne einer "Konservierung" des letzteren und gleichzeitig eine Stabilisierung der Gesamtfunktion des Näherungsschalters. Zudem ist ein derartig gesicherter Näherungsschalter bei seinem Einsatz in elektrischen Schweißanlagen unabhängig von der verwendeten Schweißstromart und -steuerung.

Zweckmäßige Ausführungen und vorteilhafte Weiterbildungen der Erfindung sind aus den nachgeordneten Unteransprüchen ersichtlich und mit ihren Merkmalen dem Fachmann ohne zusätzliche Erläuterungen verständlich.

In der anliegenden Zeichnung ist als Ausführungsbeispiel der Erfindung die Schaltungsanordnung eines magnetfeldbetätigten und störfeldgesicherten Näherungsschalters schematisch dargestellt.

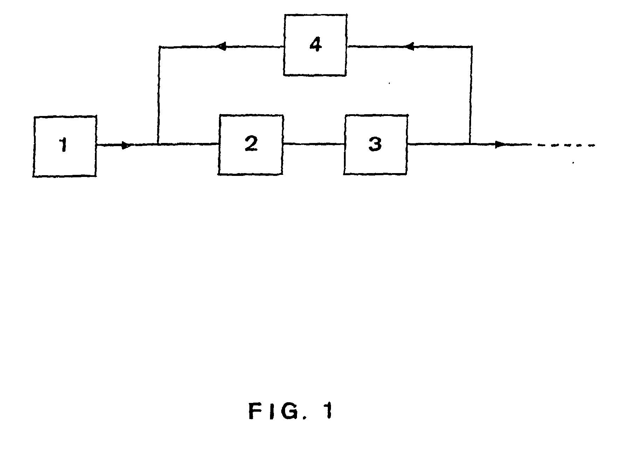

Wie aus dem Blockschaltbild gem. Fig. 1 ersichtlich, wird das von dem Magnetfeldsensor 1 in Abhängigkeit eines dafür vorgesehenen Auslösemagnetfeldes abgegebene Leitsignal über eine Verstärkerstufe 2 einer transistorierten Schaltstufe 3 zugeführt und von derselben in ein definiertes Ausgangssignal umgesetzt. Im Störfall wird alsdann das Ausgangspotential der Schaltstufe 3 vermittels eines zweiten Sensors 4, der auf ein - wie z.B. in elektrischen Schweißanlagen - intermittierend auftretendes magnetisches Fremdfeld reagiert, an den Eingang der Verstärkerstufe 2 zurückgeführt, um das von Seiten des Magnetfeldsensors 1 eingespeiste Leitsignal durch Überlagerung zu konservieren und den Näherungsschalter in seinem jeweiligen Schaltzustand unbeeinflußt durch das Störfeld zu machen, solange dieses vorhanden ist.

In dieser Anordnung handelt es sich bei dem Magnetfeldsensor 1 und bei dem Störfeldsensor 4 beispielsweise um induktive Sensoren, an deren Stelle aber ebensogut Hallsensoren, magnetoresistive Sensoren oder sogar einfache Schutzrohrkontakte treten können, wobei das jeweilige Überwachungsproblem und die zu berücksichtigenden Störmöglichkeiten Ausführung und Aufwand bestimmen.

Wesentlich ist für die einwandfreie Funktion der Schaltungsanordnung, daß die Ansprechempfindlichkeit eines Störfeldsensors 4 größer und seine Reaktivität (Schaltzeit) kleiner als die entsprechenden Eigenschaften bzw. Werte des Magnetfeldsensors 1 sind. Dementsprechend kann aber auch die Verstärkerstufe 2 gegenüber der Reaktion des Störfeldsensors 4 mit einer Signalverzögerung in Richtung der Schaltstufe 3 ausgestattet sein. Darüber hinaus können einem Magnetfeldsensor 1 innerhalb des gleichen Gehäuses mehrere Störfeldsensoren 4 beigeordnet werden und bei Bedarf untereinander magnetisch abgeschirmt sein.

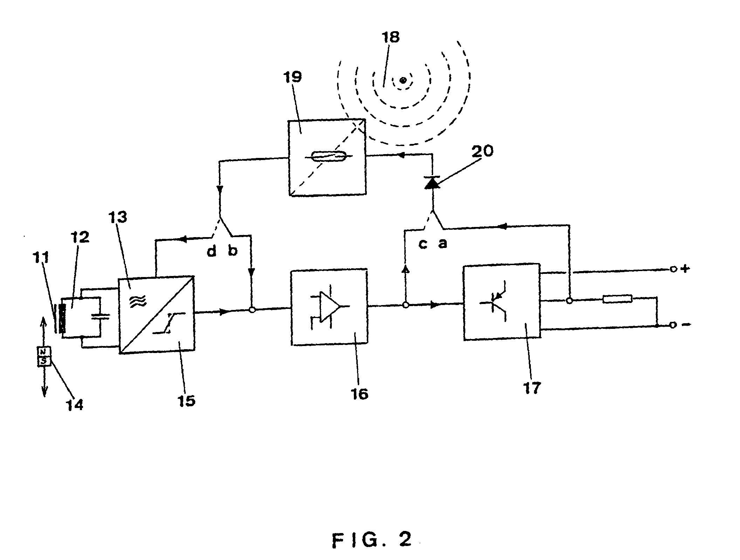

Vorteilhafte Varianten dieser Ausbildung sind aus dem erweiterten Blockschaltbild gem. Fig. 2 der Zeichnung zu ersehen.

Dementsprechend wird der durch einen hochpermeablen Amorphmetallstreifen 11 an seiner aktiven Fläche vorbedämpfte HF-Schwingkreis 12 einer Oszillatorschaltung 13 als Sensorelement des Näherungsschalters von dem (Dauer-)Magnetfeld eines sich definiert nähernden Auslösers 14 entdämpft und bei dessen Entfernen wieder bedämpft.

Dieser Vorgang ist mit einer stetigen oder sprungweisen Änderung des Oszillatorstromes verbunden, wobei der Wechsel zwischen dem vorbedämpften und dem entdämpften Zustand in ein binäres Leitsignal (15) umgesetzt wird, das als ein solches an den hochohmigen Eingang der nachgeordneten Verstärkerstufe 16 und von dort aus weiter in die Schaltstufe 17 gelangt.

Wenn dann der auf magnetische Störfelder 18 reagierende Sensor 19, vorzugsweise in Form eines Schutzrohrkontakts, schaltungsmäßig fest mit den Punkten a und b verbunden ist, wird aus der vorhandenen Signalverarbeitung (16 + 17) das niederohmige Ausgangssignal der Schaltstufe 17 pol- bzw. phasengleich dem Leitsignal von Seiten des Sensorelements 11 - 13 überlagert. - Ist der Störfeldsensor 19 dagegen auf der einen Seite an Stelle von Punkt a mit dem Punkt c verbunden, so kann bereits ein von der Verstärkerstufe 16 abgegebenes Zwischensignal dazu verwendet werden, je nach Dämpfungszustand der Sensorstufe 11 - 15 positives oder negatives Potential auf den Eingang der Verstärkerstufe 16 zurückzuschalten. Eine derartige Maßnahme erweist sich als vorteilhaft, wenn ausgangsseitig selbstschützende Schaltelemente verwendet werden, die beispielsweise bei Überlastung oder Kurzschluß die Schaltstufe 17 sperren. Des weiteren ist es möglich, bei Bedarf nur eines der beiden Potentiale rückzuübermitteln, wozu in den Schaltweg des Störfeldsensors 19 lediglich eine entsprechend gepolte Sperrdiode 20 eingesetzt zu werden braucht.

Darüber hinaus kann der Störfeldsensor 19 aber auch das der Signalverarbeitung entnommene Signal statt über Punkt b an den Eingang der Verstärkerstufe 16 bereits über Punkt d an ein bestimmendes Potential innerhalb der Sensorstufe 11 - 15 legen, um den gleichen Effekt zu erreichen.

In jedem Fall wird mit der erfindungsgemäßen Rückführung sichergestellt, daß der jeweilige Ausgangszustand des Näherungsschalters konstant aufrechterhalten bleibt, solange ein magnetisches Störfeld von irgendwo her funktionsgefährdend auf dessen sensierenden Bereich einwirkt. Insofern schützt diese Ausführung eines Näherungsschalters nicht nur dessen Funktion, sondern zur gleichen Zeit auch den ordnungsgemäßen Betriebsablauf innerhalb einer Einrichtung oder Anlage.

## Patentansprüche

1. Störfeldsicherer Näherungsschalter, bestehend aus einem Magnetfeldsensor (1), der über eine Verstärkerstufe (2) auf eine Schaltstufe (3) wirkt und einem weiten Sensor, **gekennzeichnet dadurch daß** der zweite Sensor (4) auf intermittierend auftretende magnetische Störfelder reagiert und in seinem aktivierten Zustand das niederohmige Ausgangssignal der Schaltstufe (3) zur Aufrechterhaltung des von dem Magnetfeldsensor (1) eingegebenen Leitsignals an den hochohmigen Eingang der Verstärkerstufe (2) zurückführt.

2. Störfeldsieherer Näherungsschalter nach Anspruch 1, **dadurch gekennzeichnet, daß** der Störfeldsensor (4) das Ausgangssignal der Verstärkerstufe (2) je nach dem Dämpfungszustand des Magnetfeldsensors (1) als ein positives oder als ein negatives Potential an den Eingang der Verstärkerstufe (2) zurückschaltet.

3. Störfeldsicherer Näherungsschalter nach den Ansprüchen 1 oder 2, **dadurch gekennzeichnet, daß** der Störfeldsensor (4) zur alleinigen Rückübermittlung eines positiven oder eines negativen Potentials an den Eingang der Verstärkerstufe (2) mit einer entsprechend gepolten Sperrdiode (20) in Reihe geschaltet ist.

4. Störfeldsicherer Näherungsschalter nach den Ansprüchen 1 bis 3, **dadurch gekennzeichnet, daß** der Störfeldsensor (4) das jeweilige Ausgangssignal der Schaltstufe (3) oder der Verstärkerstufe (2) funktionsbestimmend in die Oszillatorschaltung des Magnetfeldsensors (1) einleitet.

5. Störfeldsicherer Näherungsschalter nach Anspruch 1, **dadurch gekennzeichnet, daß** der Magnetfeldsensor (1) als ein von außen entdämpfbarer Schwingkreis einer HF-Oszillatorschaltung ausgebildet ist.

6. Störfeldsicherer Näherungsschalter nach Anspruch 1, **dadurch gekennzeichnet, daß** der oder mehrere Störfeldsensoren (4) als entdämpfbare HF-Oszillatoren ausgebildet sind.

7. Störfeldsicherer Näherungsschalter nach den Ansprüchen 1, 5 oder 6, **dadurch gekennzeichnet, daß** der Magnetfeldsensor (1) und/oder der bzw. die Störfeldsensoren (4) als Schutzrohrkontakte ausgebildet sind.

8. Störfeldsicherer Näherungsschalter nach den Ansprüchen 1 oder 6 und 7, **dadurch gekennzeichnet, daß** der oder die Störfeldsensoren (4) auf die mögliche Einfallrichtung von Fremdfeldern ausgerichtet sind.

9. Störfeldsicherer Näherungsschalter nach den Ansprüchen 1 bis 8, **dadurch gekennzeichnet, daß** der oder die Störfeldsensoren (4) ansprechempfindlicher sind und einen geringeren Schaltverzug als der Magnetfeldsensor (1) aufweisen.

10. Störfeldsicherer Näherungsschalter nach den Ansprüchen 1 bis 9, **dadurch gekennzeichnet, daß** der Magnetfeldsensor (1) und der oder die Störfeldsensoren (4) in einem gemeinsamen Gehäuse zusammengefaßt sind.

11. Störfeldsicherer Näherungsschalter nach Anspruch 10, **dadurch gekennzeichnet, daß** zwischen den einzelnen Sensoren (1, 4) magnetische Abschirmungen vorgesehen sind.

## Claims

1. A proximity switch insensitive to interfering fields comprising a magnetic field sensor (1), which acts via an amplifier stage (2) on a switching stage (3), and a second sensor, **characterized in that** the second sensor (4) reacts to intermittently occurring magnetic interference fields and, in its activated state, returns the low impedance output signal of the switching stage (3) for the maintenance of the lead signal input by the magnetic field sensor (1) to the high impedance input of the amplifier stage (2).

2. A proximity switch insensitive to interfering fields in accordance with claim 1, **characterized in that** the interference field sensor (4) switches the output signal of the amplifier stage (2) back to the input of the amplifier stage (2) as a positive or as a negative potential depending on the state of damping of the magnetic field sensor (1).

3. A proximity switch insensitive to interfering fields in accordance with claim 1 or claim 2, **characterized in that** the interference field sensor (4) is connected in series to a blocking diode (20) having a corresponding polarity for the sole transmission of a positive or of a negative potential back to the input of the amplifier stage (2).

4. A proximity switch insensitive to interfering fields in accordance with claims 1 to 3, **characterized in that** the interference field sensor (4) leads the respective output signal of the switching stage (3) or of the amplifier stage (2) into the oscillator circuit of the magnetic field sensor (1) in a functionally determining manner.

5. A proximity switch insensitive to interfering fields in accordance with claim 1, **characterized in that** the magnetic field sensor (1) is made as a resonant circuit of an RF oscillator which can be deattenuated from the outside.

6. A proximity switch insensitive to interfering fields in accordance with claim 1, **characterized in that** the interference field sensor (4), or a plurality thereof, are made as RF oscillators which can be deattenuated.

7. A proximity switch insensitive to interfering fields in accordance with claim 1, claim 5, or claim 6, **characterized in that** the magnetic field sensor (1) and/or the interference field sensor or sensors (4) are made as reed contacts.

8. A proximity switch insensitive to interfering fields in accordance with claim 1, claim 6 or claim 7, **characterized in that** the interference field sensor or sensors (4) are aligned to the possible direction of incidence of external fields.

9. A proximity switch insensitive to interfering fields in accordance with claims 1 to 8, **characterized in that** the interference field sensors (4) have a higher response sensitivity and a lower switching delay than the magnetic field sensor (1).

10. A proximity switch insensitive to interfering fields in accordance with claims 1 to 9, **characterized in that** the magnetic field sensor (1) and the interference field sensor or sensors (4) are combined in a common housing.

11. A proximity switch insensitive to interfering fields in accordance with claim 10, **characterized in that** magnetic shields are provided between the individual sensors (1, 4).

## Revendications

1. Commutateur de proximité protégé contre les champs parasites, comprenant un capteur de champ magnétique (1), qui agit au moyen d'un étage amplificateur (2) sur un étage de commutation (3) et un autre capteur, **caractérisé en ce que** le second capteur (4) réagit à des champs parasites magnétiques apparaissant par intermittence, et dans son état activé, ramène le signal de sortie de basse impédance de l'étage de commutation (3) pour la conservation du signal conducteur entré par le capteur de champ magnétique (1) à l'entrée à haute impédance de l'étage amplificateur (2).

2. Commutateur de proximité protégé contre les champs parasites selon la revendication 1, **caractérisé en ce que** le capteur de champ parasite (4) ramène le signal de sortie de l'étage amplificateur (2) en fonction de l'état d'amortissement du capteur de champ magnétique (1) sous la forme d'un potentiel positif ou d'un potentiel négatif à l'entrée de l'étage amplificateur (2).

3. Commutateur de proximité protégé contre les champs parasites selon les revendications 1 ou 2, **caractérisé en ce que** le capteur de champ parasite (4) pour la retransmission unique d'un potentiel positif ou d'un potentiel négatif à l'entrée de l'étage amplificateur (2) est monté en série avec une diode de blocage (20) polarisée de façon appropriée.

4. Commutateur de proximité protégé contre les champs parasites selon les revendications 1 à 3, **caractérisé en ce que** le capteur de champ parasite (4) envoie le signal de sortie respectif de l'étage de commutation (3) ou de l'étage amplificateur (2) de façon déterminante pour le fonctionnement dans le circuit oscillateur du capteur de champ magnétique (1).

5. Commutateur de proximité protégé contre les champs magnétiques selon la revendication 1, **caractérisé en ce que** le capteur de champ magnétique (1) est conçu comme un circuit oscillant d'un circuit oscillateur H.F. dont l'amortissement peut être compensé par l'extérieur.

6. Commutateur de proximité protégé contre les champs parasites selon la revendication 1, **caractérisé en ce que** le ou plusieurs capteurs de champ parasite (4) sont réalisés sous la forme d'oscillateurs H.F. dont l'amortissement peut être compensé.

7. Commutateur de proximité protégé contre des champs parasites selon les revendications 1, 5 ou 6, **caractérisé en ce que** le capteur de champ magnétique (1) et/ou le ou les capteurs de champ magnétique (4) sont conçus comme des contacts à lame souple.

8. Commutateur de proximité protégé contre les champs parasites selon les revendications 1 ou 6 et 7, **caractérisé en ce que** le ou les capteurs de champ parasite (4) sont orientés sur la direction d'incidence possible de champs étrangers.

9. Commutateur de proximité protégé contre les champs parasites selon les revendications 1 à 8, **caractérisé en ce que** le ou les capteurs de champ parasite (4) ont une plus grande sensibilité de déclenchement et présentent un retard de commutation plus faible que le capteur de champ magnétique (1).

10. Commutateur de proximité protégé contre les champs magnétiques selon les revendications 1 à 9, **caractérisé en ce que** le capteur de champ magnétique (1) et le ou les capteurs de champ magnétique (4) sont regroupés dans un boîtier commun.

11. Commutateur de proximité protégé contre les champs parasites selon la revendication 10, **caractérisé en ce qu'**il est prévu des blindages magnétiques entre les différents capteurs (1, 4).
